# EUROPEAN PATENT APPLICATION

(11) **EP 4 180 149 A1**
(43) Date of publication of application: **17.05.2023**
(21) Application number: 21837586.3
(22) Date of filing: 20.04.2021
(51) Int. Cl.: B22F 1/00, B22F 9/28, C22C 33/02, C22C 38/00, H01F 41/02, H01F 1/147, H01F 1/26, C23C 16/08, H01F 27/255, B22F 3/00, B22F 3/02

(54) **METAL POWDER AND PRESSED POWDER BODY THEREOF, AND PRODUCTION METHODS THEREFOR**

(30) Priority: 10.07.2020 JP 2020119007
(71) Applicant: JFE Mineral Company, Ltd., Tokyo 105-0014 (JP)
(72) Inventor: MATSUKI, Kensuke, Tokyo 105-0014 (JP); YAMANE, Hiroshi, Tokyo 105-0014 (JP); FUKUDOME, Daiki, Tokyo 105-0014 (JP)
(74) Representative: Grünecker Patent- und Rechtsanwälte PartG mbB
(86) International application number: PCT/JP2021/015972
(87) International publication number: WO 2022/009502

(57) **Abstract**

To provide a metal powder capable of producing a dust core having a high saturation magnetic flux density, excellent rust resistance, and a low iron loss.

The metal powder includes from 1.0% to 15.0% of Si, from 1.0% to 13.0% of Cr, from 10 ppm to 10000 ppm of Cl, from 100 ppm to 10000 ppm of S (sulfur), and from 0.2% to 7.0% of O (oxygen) by mass concentration, the remainder including Fe and unavoidable impurities, in which the average particle diameter of the metal powder is from 0.1 um to 2.0 µm. This facilitates the production of a dust core having a high magnetic flux density, excellent rust resistance, and a low iron loss.

## Description

### Technical Field

The present invention relates to a metal powder and its green compact, especially to a metal powder including an iron alloy and its green compact bonded by a resin that are suitable for inductor cores used at high frequencies, and to the method for producing them.

### Background Art

In the field of portable devices, especially compact portable devices represented by smartphones and tablet PCs, the recent years have seen a remarkable increase in functionality and multifunctionality. In line with this, there is a strong demand for the choke coils in the installed power supply circuits to accommodate the increased number of units and higher currents associated with the increased functionality of integrated circuit ICs. In addition, in response to the demand for smaller and thinner portable devices, there is also a strong demand for smaller and lower-profile coils themselves.

Ferrite material has been used for choke coils. However, due to the low saturation magnetic flux density of ferrite, when the core is downsized, the DC superposition characteristics deteriorate due to core saturation, and a large current could not flow. For this reason, iron-based metallic magnetic particles with high saturation magnetic flux density have recently attracted attention as a core (magnetic core) material for small inductors.

For example, Patent Literature 1 discloses a soft magnetic metal powder with a composition formula of Fe_{100-a-b}SiₐCr_{b} (0 ≤ a ≤ 8, 0 < b ≤ 3 by % by weight), in which a part or the entire surface of the powder is covered with an insulating oxide and the Cr concentration at the powder surface is higher than at the powder center. The disclosure states that the oxygen content of the entire soft magnetic metal powder including the insulating oxide is preferably 10 % by mass or less. It also states that the soft magnetic metal powder is produced by mixing the raw powder with an alkoxide solution, drying it, and then heat-treating it at 700°C or higher, which can significantly reduce both eddy current loss and hysteresis loss of the dust core.

Patent Literature 2 discloses an iron-based soft magnetic powder material which is crystalline and whose basic composition is represented by the composition formula Fe_{100-x-y}SiₓCr_{y} (wherein ×: from 0 to 15 at%, y: from 0 to 15 at%, x+y: from 0 to 25 at%), in which from 0.05 to 4.0 parts by mass of one or more magnetically modifying trace components selected from the group 4 to 6 transition metals of Nb, V, Ta, Ti, and W are added to 100 parts by mass of the total amount of the above compositional formula. It states that the inclusion of the magnetically modifying trace component reduces magnetic anisotropy and reduces internal strain. The dust core produced with the iron-based soft magnetic powder described in Patent Literature 2 can achieve high magnetic permeability and do not increase magnetic core loss.

Patent Literature 3 discloses a magnetic material that is a particle compact obtained by heat-treating metal particles including a Fe-Cr-Si alloy in an oxidizing atmosphere. It states that the metal particles to be used are Fe-Cr-Si alloy particles in which Fe_{Metal}/(Fe_{Metal} + Fe_{oxide}) is 0.2 or more, where Fe_{oxide} is the sum of the integrals of the peaks at 709.6 eV, 710.7 eV and 710.9 eV by XPS of the metal particles before molding, and Fe_{Metal} is the integral value of the peak at 706.9 eV. The Cr content ranges from 2.0 wt% to 15 wt%. It states that the resulting particle compact has oxide films including a plurality of metal particles and an oxide of the metal particles covering the metal particles, and bonds between the oxide films, which results in a magnetic material with high magnetic permeability and high insulation resistance.

Patent Literature 4 discloses a Fe-based soft magnetic metal powder with a composition including from 7 to 9% Si and from 2 to 8% Cr by % by mass in Fe together with unavoidable impurities, with an average particle diameter D50 of 1 to 40 µm, and an oxygen content suppressed to 0.60 % by mass or less. It states that this allows the magnetic core to have high magnetic permeability, low iron loss, and excellent corrosion resistance.

Patent Literature 5 discloses a soft magnetic metal powder which is an iron-based powder including from 100 to 995 ppm of carbon and from 3 to 15% of Si by % by mass%, and states that the oxygen content in the particles is preferably 500 ppm or less, and that the powder may include from 30 to 80% of Ni and 10% or less of Cr. It states that this produces a soft magnetic metal powder with low coercivity, and that the use of this soft magnetic metal powder improves the dust core loss.

Patent Literature 6 discloses a Fe-based metal powder including, by mass%, from 1 to 10% Si, from 1 to 13% Cr, from 10 to 10000 ppm Cl, and preferably from 1 to 7% O (oxygen) by % by mass, and has an average particle diameter of from 0.1 to 3.0 um. It states that this enables the production of a metal powder for inductors having lower coercivity, higher affinity with resin, and higher rust resistance than prior art magnetic materials, and enables the production of a dust core having a high saturation magnetic flux density and a low iron loss.

### Citation List

### Patent Literature

Patent Literature 1: JP 2008-195986 A
Patent Literature 2: Japanese Patent No. 5354101
Patent Literature 3: JP 2013-26356 A
Patent Literature 4: JP 2014-78629 A
Patent Literature 5: JP 2017-92481 A
Patent Literature 6: JP 2020-76135 A

### Summary of Invention

### Technical Problem

However, in the technology described in Patent Literatures 1 to 5, the affinity between the metal powder and the resin is low, and it is difficult to coat the entire surface of the metal powder with the resin. As a result, lubrication between metal powders is poor, and the filling density of metal powders cannot be increased while ensuring electrical insulation between them, making it impossible to increase magnetic permeability and magnetic flux density as a dust core.

In the technique described in Patent Literature 6, the addition of Cl improves the affinity with resin and the filling density, thereby improving the magnetic core characteristics such as magnetic core loss (hereinafter referred to as "iron loss") as a dust core. However, cores for inductors used in high-frequency applications are constantly struggling with heat generation, and the magnetic core characteristics in terms of low iron loss (i.e., reduced heat generation) are not yet sufficient to meet the strict requirements for further miniaturization and thinning.

An object of the present invention is to provide a metal powder and its green compact having low coercivity, high affinity with resin, excellent rust resistance, and high saturation magnetization, and a method for producing them, which solve the problems of prior art and enable the production of a dust core having excellent magnetic core characteristics of high magnetic flux density and low iron loss that meet the more stringent requirements for miniaturization and thinning as cores for inductors used at high frequencies.

### Solution to Problem

In order to achieve the aforementioned objectives, the present inventors have diligently studied the magnetic and electrical properties of the green compact. As a result, they found that it is essential to use a metal powder (iron alloy powder) including appropriate amounts of Si and Cr, as well as appropriate amounts of Cl and S (sulfur) in Fe. In particular, they newly found that the presence of the appropriate amounts of Cl and S (sulfur) increases the affinity with resin and the filling density of the powder, facilitating the production of dust cores with a high magnetic flux density and a low iron loss.

Based on these findings, the present invention was completed after further study. The gist of the invention is as follows.
[1] A metal powder including from 1.0% to 15.0% of Si, from 1.0% to 13.0% of Cr, from 10 ppm to 10000 ppm of Cl, from 100 ppm to 10000 ppm of S (sulfur), and from 0.2% to 7.0% of O (oxygen) by mass concentration, the remainder including Fe and unavoidable impurities, in which the average particle diameter of the metal powder is from 0.1 um to 2.0 µm.
[2] A green compact which is a bonded product of the metal powder described in [1] and a resin.
[3] The green compact according to [2], in which the resin is a thermosetting resin, a UV curable resin, or a thermoplastic resin.
[4] A method for producing a metal powder by chemical vapor deposition, in which the metal powder includes from 1.0% to 15.0% of Si, from 1.0% to 13.0% of Cr, from 10 ppm to 10000 ppm of Cl, from 100 ppm to 10000 ppm of S (sulfur), and from 0.2% to 7.0% of O (oxygen) by mass concentration, the remainder including Fe and unavoidable impurities, in which the average particle diameter of the metal powder is from 0.1 um to 2.0 µm.
[5] A method for producing a green compact, including producing a metal powder by chemical vapor deposition, mixing the metal powder with a resin, and compression molding the mixture, in which the metal powder includes from 1.0% to 15.0% of Si, from 1.0% to 13.0% of Cr, from 10 ppm to 10000 ppm of Cl, from 100 ppm to 10000 ppm of S (sulfur), and from 0.2% to 7.0% of O (oxygen) by mass concentration, the remainder including Fe and unavoidable impurities.
[6] The method for producing a green compact according to [5], in which the resin is a thermosetting resin, a UV curable resin, or a thermoplastic resin.

### Advantageous Effects of Invention

The present invention has a remarkable industrial effect by facilitating the production of a metal powder having a low coercivity, excellent resin adhesion, and rust resistance, which facilitates the production of a dust core having a high magnetic flux density and a low iron loss.

### Description of Embodiments

The embodiments of the present invention are described in detail below.

### [Composition of metal powder]

The metal powder of the present invention is a Fe-based metal powder (iron alloy powder). Specifically, the metal powder of the present invention is a metal powder including from 1.0% to 15.0% of Si, from 1.0% to 13.0% of Cr, from 10 ppm to 10000 ppm of Cl, from 100 ppm to 10000 ppm of S (sulfur), and from 0.2% to 7.0% of O (oxygen) by mass concentration, the remainder including Fe and unavoidable impurities, in which the average particle diameter of the metal powder is from 0.1 um to 2.0 um. Hereinafter, % and ppm in the composition mean mass concentration.

Next, the reason for the composition limitation is described.

### [Si: from 1.0% to 15.0%]

In a Fe-based metal powder (iron alloy powder), Si is an element that solidly dissolves in the metal (Fe) and contributes to an increase in the electrical resistance and a decrease in the magnetostriction of the metal powder. The magnetostriction decreases as the Si content increases, reaching almost zero at a Si content of about 6.5%, and further decreases to a negative value as the Si content is increased. On the other hand, electrical resistance (specific resistance) increases significantly as the Si content increases. A decrease in the absolute value of magnetostriction contributes to a reduction in hysteresis loss, and an increase in electrical resistance contributes to a reduction in eddy current loss.

For use in DC magnetic fields or at frequencies as low as commercial frequencies, hysteresis loss accounts for a large proportion of the total loss, so the loss is minimum at a Si content of around 6.5%, and a content around this composition is suitable. However, in the region of higher operating frequency, the proportion of eddy current loss in the total loss increases, so a composition with a higher Si content is suitable to minimize the loss. As the operating frequency increases further to the MHz range, the proportion of eddy current loss in the total loss increases further, and a composition with a higher Si content is suitable to minimize the loss.

Thus, depending on the application, Si has a suitable effect in a wide composition range, but a Si content less than 1.0% is not suitable, because neither the reduction of magnetostriction nor the increase of electrical resistance is sufficient. In addition, when the Si content is more than 15.0%, the absolute value of magnetostriction is also large and the decrease in saturation magnetization is very large, so the produced dust core does not have the desired magnetic properties. For this reason, the Si content was limited to the range of from 1.0% to 15.0%. The Si content is preferably from 3.0% to 15.0%, and more preferably from 6.0% to 14.0%.

### [Cr: from 1.0% to 13.0%]

Cr is an element that decreases the magnetic properties of the metal powder but improves its corrosion resistance. In order to obtain the effect of corrosion resistance in the metal powder of the present invention, the Cr content is preferably 1.0% or more. When the Cr content is less than 1.0%, rusting is more likely occur on the particle surface. On the other hand, a high Cr content of more than 13.0% results in a decrease in saturation magnetization (emu/g). For this reason, the Cr content was limited to the range of from 1.0% to 13.0%. The Cr content is preferably from 1.0% to 6.0%, and more preferably from 1.0% to 4.0%. Here, corrosion resistance refers to rust resistance, which will be described later.

### [Cl: from 10 ppm to 10000 ppm]

Cl (chlorine) is an element that contributes to improving the affinity between the metal particle surface and the resin, and has the effect of increasing the filling density of the metal powder when made into a dust core, thereby increasing the magnetic flux density of the dust core. In order to achieve this effect, a Cl content of 10 ppm or more is required. When the Cl content is less than 10 ppm, the affinity between the surface of the metal powder particles and the resin is low, and voids are easily generated around the metal powder particles, making it impossible to achieve the desired filling density. On the other hand, a high Cl content of more than 10000 ppm may accelerate rusting due to moisture absorption from the surface. For this reason, the Cl content was limited to the range of from 10 ppm to 10000 ppm. The Cl content is preferably from 10 ppm to 1000 ppm, and more preferably from 10 ppm to 500 ppm.

### [S (sulfur): from 100 ppm to 10000 ppm]

S (sulfur) is an element that, when added in the presence of Cl, further improves the affinity between the surface of the metal particles and the resin, and further increases the filling density of the metal powder (i.e., the volume fraction of the metal powder in the resin) when made into a dust core compared to when Cl is added alone, and the increase in filling density has the effect of greatly improving the magnetic permeability of the dust core. In order to achieve this effect, an S content of 100 ppm or more is required. When the S (sulfur) content is less than 100 ppm, the additional effect of improving the affinity between the powder particle surface and the resin is not observed, and only 70% filling density, the same level as with the addition of Cl alone, can be achieved. On the other hand, a high S content of more than 10000 ppm will cause rusting due to moisture absorption from the surface, which decreases affinity with the resin and also decreases filling density. For this reason, in the present invention, the S (sulfur) content was limited to the range of from 100 ppm to 10000 ppm. The S content is preferably from 200 ppm to 8000 ppm, and more preferably from 300 ppm to 6000 ppm.

As can be seen from the data of the examples described below, the improvement in the volume fraction of metal powder in the dust core here is apparently small, from 70% in the comparative example to 72% in the example, an improvement of 2%. However, this further +2% is an improvement over the 70% that approaches the geometric volume fraction limit of 74% for the single-size hardsphere closest packing model, and is a volume fraction that cannot be reached unless an ideal arrangement is achieved, in which the larger powder particles that form the framework of the green compact are filled to near their geometric limits, and the gaps between them are filled with smaller powder particles. This is a volume fraction that would be difficult to achieve if voids existed between the powder particles and the resin, given the constraint that both the filling ratio of the powder particles and the insulation by the resin on the surface of the powder particles are necessary conditions. The present inventors have found that the addition of S (sulfur) in the presence of Cl has the effect of imparting an affinity with the resin that is sufficient to allow the resin to follow the particles without detaching them from the surface, even in this densely filled state.

The further improvement of +2%, with a volume fraction of metal powder above 70%, is also significant from the standpoint of magnetic properties. The iron loss is already at a considerably low level when Cl is added alone (see Patent Literature 6 described above), and it is difficult to further reduce the iron loss.

Since the saturation magnetic flux density of a dust core, one of the factors affecting the iron loss of a dust core, is almost proportional to the volume fraction of metal powder in the dust core, no further significant improvement can be expected from the stage near the upper limit of the volume fraction of filling. However, the magnetic permeability of the dust core, which is also a factor that greatly affects the iron loss of the dust core, is greatly affected by the distance between the particles, so as the filling limit (that is, the distance between the particles is zero) is approached, the antimagnetic field decreases rapidly and the magnetic permeability increases rapidly. Therefore, the steady improvement of the volume fraction of the metal powder leads to a decrease in iron loss, and the present invention has resulted in an even greater reduction of the iron loss of the dust core, which was already at a sufficiently small level before the volume fraction was improved.

### [O (oxygen): from 0.2% to 7.0%]

O (oxygen) exists as an oxide on the surface and inhibits the activation of the metal powder surface. In order to achieve this effect, the O (oxygen) content is preferably 0.2% or more. A low O (oxygen) content does not adversely affect the magnetic properties of the powder, but if the O content is less than 0.2%, the metal powder surface is active, easily ignited, and difficult to handle in the atmosphere. On the other hand, a high O content of more than 7.0% results in a decrease in saturation magnetization. For this reason, the O (oxygen) content was limited to the range of from 0.2% to 7.0%. The O content is preferably from 0.3% to 3.0%, and more preferably from 1.0% to 2.0%.

### [Unavoidable impurities]

The remainder, other than the above components, is Fe and unavoidable impurities.

Examples of the impurity element include Ni. When Fe-Ni alloy scrap, austenitic stainless steel scrap, or other raw material is used as a Fe source, Ni will be mixed in as an impurity element. Ni is an element that lowers the saturation magnetization of the metal powder when mixed as a secondary material or impurity to lower the Fe content, and should be reduced as much as possible. However, compared to other impurity elements, Ni does not increase the coercivity and has a slower effect on lowering saturation magnetization, so a Ni content of 10% or less is acceptable. In order to improve the saturation magnetic flux density as a core, the Ni content is more preferably 5% or less, and even more preferably 3% or less.

Examples of unavoidable impurities other than Ni include C, N, P, Mn, Cu, and Al. These elements decrease the saturation magnetization of the metal powder, and a total content of 3% or less is acceptable because it does not cause a decrease in magnetic properties that can be said to be fatal in practical use, but a total content of 1% or less is more preferable.

### [Average particle diameter of metal powder]

The metal powder of the present invention is a particle (powder) with an average particle diameter of from 0.1 um to 2.0 um having the composition described above. The "average particle diameter" here is defined as D50 on a number basis, which is obtained by observing metal powder particles with a scanning electron microscope (SEM), taking images, and analyzing SEM images of 1,000 to 2,000 measured particles at a magnification of 20,000 times. When the average particle diameter is less than 0.1 um, agglomeration tends to occur when mixed with a resin, and the filling ratio does not increase, resulting in a lower saturation magnetic flux density of the dust core. On the other hand, when the average particle diameter exceeds 2.0 um, iron loss, especially at high frequencies, increases. For this reason, the average particle diameter of the metal powder in the present invention was limited to the range of from 0.1 um to 2.0 um. The average particle diameter is preferably from 0.1 um to 1.5 um, and more preferably from 0.1 um to 1.0 µm.

### [Magnetic properties of metal powder]

### [Coercivity]

The coercivity of the metal powder in the present invention was measured by placing the metal powder in a specified container, melting and solidifying paraffin to fix it, and using a vibrating sample magnetometer (VSM) at an applied magnetic field of 1200 kA/m. The coercivity is preferably small for applications such as the magnetic cores of inductors and transformers, which are the objectives of this invention.

### [Saturation magnetization]

The saturation magnetization of the metal powder in the present invention was measured in the same manner as the coercivity measurement described above, using VSM at an applied magnetic field of 1200 kA/m. For applications such as the magnetic cores of inductors and transformers, which are the objectives of the present invention, the saturation magnetization is preferably large.

### [Rust resistance of metal powder]

In order to measure the rust resistance of the metal powder, the metal powder was embedded and fixed in a resin, and then the cross section was mirror-polished to make a test piece for rust resistance measurement. After the specimens were kept in a thermostatic chamber for a specified time, 20 particles in the specimens were randomly selected and observed for rusting, and the percentage of rusting particles (rusting ratio) was calculated. The thermostatic chamber was maintained at a temperature of 60°C and a relative humidity of 95%. The retention time in the thermostatic chamber was 2000 hours. The rusting ratio of the metal powder thus obtained is preferably 10% or less, which does not cause any defects in use, and more preferably 5% or less.

### [Method for producing metal powder]

Next, the method for producing the metal powder will be described.

The metal powder of the present invention can be produced by gas atomization or water atomization, but is preferably produced by chemical vapor deposition (hereinafter referred to as "CVD").

In the CVD process, the chloride gas of each element produced by reacting the alloying elements of Fe, Si, and Cr with chlorine gas at high temperature, or the mixture gas of the chloride of each element of Fe, Si, and Cr vaporized by heating to high temperature and S (sulfur) vaporized at high temperature in a predetermined ratio, is mixed with hydrogen at a suitable temperature to reduce the chloride to obtain a metal powder with the desired composition including Si, Cr, and S (sulfur). The method for producing a metal powder by CVD is preferred because the concentration of the chloride gas, reaction temperature, and reaction time can be adjusted to achieve the desired average particle diameter.

After the reaction (reduction reaction), the resulting metal powder is further subjected to a washing step. In the washing step, the resulting metal powder is washed using a solvent to adjust the Cl content to 10000 ppm or less. The solvent used here is preferably a solvent that dissolves the unreduced chlorides and byproducts formed by the reduction reaction. Examples of such solvents include water-soluble inorganic solvents such as water, and organic solvents such as aliphatic alcohols such as ethyl alcohol.

### [Green compact]

Dispersing the metal powder of the present invention in a resin facilitates the production of a green compact having a high filling density and a low magnetic core loss.

The green compact can be produced by known methods without any special restrictions. First, the metal powder and a resin as a binder are mixed to obtain a mixture in which the metal powder is dispersed in the resin. As necessary, the resulting mixture may be granulated to form a granulated product. The mixture or granulated product is compressed and molded to obtain a compact (green compact).

The resin to be mixed as a binder is preferably a resin that improves affinity with the aforementioned metal powder surface, such as a thermosetting resin, a UV curable resin, or a thermoplastic resin. Examples of the thermosetting resin include epoxy resins, phenol resins, urea resins, melamine resins, unsaturated polyester resins, polyurethane resins, and diallyl phthalate resins. Examples of the UV curable resin include urethane acrylate resins, epoxy acrylate resins, and polyester acrylate resins. Examples of the thermoplastic resin include polyphenylene sulfide resins and nylon resins (polyamide resins). These resins were effective in improving affinity with the aforementioned metal powder surfaces.

The mixture or granulated powder is then filled into a mold and compression molded to obtain a compact (dust core) having a shape of the green compact to be produced. When the thermosetting resin is used as the resin, heat treatment may be performed at 50°C to 200°C. The resulting green compact is a tightly bonded product of the metal powder and resin.

### [Iron loss of green compact]

Magnetic core loss (iron loss) is a loss that occurs in coils of inductors, transformers, and other devices that have magnetic cores made of magnetic material due to the physical properties of the magnetic core, and is one of the factors that reduce the efficiency of transformers and other devices. To measure iron loss, a ring-shaped mold (outer diameter: 13.0 mm, inner diameter: 8.0 mm) was filled with a mixture of metal powder mixed and dispersed in an epoxy resin and pressed, then the resin was cured to form a toroidal core (dust core) with a thickness of 3.0 mm and given 20 turns on the primary side and 20 turns on the secondary side to make a coil. The coil was measured for iron loss using a B-H analyzer (SY-8218 manufactured by Iwantsu Electric Co., Ltd.) at a magnetic flux density of 0.025 T and a frequency of 1 MHz. The iron loss of the green compact is 500 kW/m³ or less, and more preferably 450 kW/m³ or less.

### Examples

The following is a specific description of the present invention with an example using the CVD process, which is one embodiment of the aforementioned method for producing a metal powder. However, the present invention is not limited only to the example described below.

First, chlorides of Fe, Si, and Cr were prepared as raw materials. Then, these chlorides were individually heated to a high temperature (from 900°C to 1200°C, preferably about 1000°C) by a CVD reactor to vaporize the chlorides to produce chloride gas of each element. In addition, S (sulfur) was vaporized and heated at high temperatures (from 900°C to 1200°C) to produce a gas. The chloride gas of each element produced and the gas produced by vaporizing S (sulfur) were mixed at different mixing ratios to obtain mixed gases composed mainly of metal chlorides to achieve the desired metal powder compositions. The resulting gas mixtures were individually sent to a CVD reactor together with hydrogen gas and nitrogen gas (gas temperature: from 900 to 1200°C, gas flow rate: from 10 Nl/min to 500 Nl/min) as a carrier gas, and reacted at the specified reactor temperature (from 900°C to 1200°C) to reduce chlorides and obtain a metal powder. The composition of the metal powder is controlled by the mixing ratio of metal chloride gas and others as described above, and the average particle diameter is controlled by the chloride gas concentration of the raw material, high and low reaction temperatures, and long and short reaction times.

The resulting metal powder was then subjected to a washing step using pure water to adjust the Cl content.

The composition of the produced metal powders, their powder properties, and the properties of the green compacts are shown in Table 1.

Here, the content of alloying elements (Si and Cr) in the metal powder was measured using inductively coupled plasma (ICP). The Cl, S (sulfur), and O (oxygen) content in the metal powder were measured using the combustion method. The obtained metal powder was observed and imaged by the aforementioned method and conditions using SEM, and D50 was determined by image analysis to be the average particle diameter.

The magnetic properties (coercivity and saturation magnetization) and rust resistance of the metal powders obtained and the filling density (volume fraction) and iron loss of the green compacts of the metal powders were studied. The test method is as described above, and the specific method is as follows.

For magnetic properties, the coercivity and saturation magnetization of the various metal powders obtained were measured using a vibrating sample magnetometer (manufactured by Toei Industry Co., Ltd.).

For rust resistance, the various metal powders obtained were observed for rusting by the rust resistance measurement test described above, and the percentage of rusting particles (rusting ratio) was calculated.

The filling density was represented by a volume-based proportion (volume fraction: %) of the metal powder in the resin.

Iron loss was also measured using the method and conditions described above.

The results obtained are listed together in Table 1.

**[Table 1]**

| Metal powder No. | Content (% by mass) (*: ppm by mass) | | | | | | Metal powder properties | | | | Green compact properties | | Remarks |
|---|---|---|---|---|---|---|---|---|---|---|---|---|---|
| | Si | Cr | Cl* | S* | O | Fe | Average particle diameter D50 (µm) | Magnetic properties | | Rust resistance | Metal powder volume fraction in resin(%) | Iron loss (kW/m³) | |
| | | | | | | | | Coercivity (Oe) | Saturation magnetization (emu/g) | Rusting ratio (%) | | | |
| 1 | 3.0 | 3.0 | 50 | 500 | 0.3 | bal. | 0.5 | 9 | 191 | 0 | 72 | 480 | Example |
| 2 | 6.0 | 3.0 | 50 | 500 | 0.3 | bal. | 0.5 | 9 | 185 | 0 | 72 | 450 | Example |
| 3 | 8.0 | 3.0 | 50 | 500 | 0.3 | bal. | 0.5 | 8 | 181 | 0 | 72 | 440 | Example |
| 4 | 10.0 | 3.0 | 50 | 500 | 0.3 | bal. | 0.5 | 9 | 179 | 0 | 72 | 440 | Example |
| 5 | 11.0 | 3.0 | 50 | 500 | 0.3 | bal. | 0.5 | 10 | 178 | 0 | 72 | 440 | Example |
| 6 | 12.0 | 3.0 | 50 | 500 | 0.3 | bal. | 0.5 | 10 | 177 | 0 | 72 | 430 | Example |
| 7 | 13.0 | 3.0 | 50 | 500 | 0.3 | bal. | 0.5 | 11 | 175 | 0 | 72 | 440 | Example |
| 8 | 14.0 | 3.0 | 50 | 500 | 0.3 | bal. | 0.5 | 11 | 173 | 0 | 72 | 450 | Example |
| 9 | 15.0 | 3.0 | 50 | 500 | 0.3 | bal. | 0.5 | 12 | 171 | 0 | 72 | 480 | Example |
| 10 | 0.1 | 3.0 | 50 | 500 | 1.0 | bal. | 0.5 | 35 | 200 | 0 | 72 | 2500 | Comparative Example |
| 11 | 1.0 | 3.0 | 50 | 500 | 1.0 | bal. | 0.5 | 10 | 195 | 0 | 72 | 500 | Example |
| 12 | 3.0 | 3.0 | 50 | 500 | 1.0 | bal. | 0.5 | 9 | 190 | 0 | 72 | 490 | Example |
| 13 | 8.0 | 3.0 | 50 | 500 | 1.0 | bal. | 0.5 | 8 | 180 | 0 | 72 | 450 | Example |
| 14 | 10.0 | 3.0 | 50 | 500 | 1.0 | bal. | 0.5 | 9 | 178 | 0 | 72 | 450 | Example |
| 15 | 11.0 | 3.0 | 50 | 500 | 1.0 | bal. | 0.5 | 10 | 177 | 0 | 72 | 450 | Example |
| 16 | 12.0 | 3.0 | 50 | 500 | 1.0 | bal. | 0.5 | 10 | 176 | 0 | 72 | 440 | Example |
| 17 | 13.0 | 3.0 | 50 | 500 | 1.0 | bal. | 0.5 | 11 | 174 | 0 | 72 | 450 | Example |
| 18 | 14.0 | 3.0 | 50 | 500 | 1.0 | bal. | 0.5 | 11 | 172 | 0 | 72 | 460 | Example |
| 19 | 15.0 | 3.0 | 50 | 500 | 1.0 | bal. | 0.5 | 12 | 170 | 0 | 72 | 490 | Example |
| 20 | 20.0 | 3.0 | 50 | 500 | 1.0 | bal. | 0.5 | 40 | 150 | 0 | 72 | 2800 | Comparative Example |
| 21 | 8.0 | 0.1 | 50 | 500 | 1.0 | bal. | 0.5 | 50< | 140 | 100 | 40 | 2100 | Comparative Example |
| 22 | 8.0 | 1.0 | 50 | 500 | 1.0 | bal. | 0.5 | 8 | 183 | 0 | 72 | 460 | Example |
| 23 | 10.0 | 1.0 | 50 | 500 | 1.0 | bal. | 0.5 | 9 | 181 | 0 | 72 | 450 | Example |
| 24 | 12.0 | 1.0 | 50 | 500 | 1.0 | bal. | 0.5 | 10 | 179 | 0 | 72 | 450 | Example |
| 25 | 14.0 | 1.0 | 50 | 500 | 1.0 | bal. | 0.5 | 11 | 177 | 0 | 72 | 460 | Example |
| 26 | 8.0 | 3.0 | 50 | 500 | 1.0 | bal. | 0.5 | 8 | 180 | 0 | 72 | 450 | Example |
| 27 | 8.0 | 5.0 | 50 | 500 | 1.0 | bal. | 0.5 | 8 | 175 | 0 | 72 | 500 | Example |
| 28 | 8.0 | 15.0 | 50 | 500 | 1.0 | bal. | 0.5 | 50< | 120 | 0 | 72 | 3000< | Comparative Example |
| 29 | 8.0 | 3.0 | 5 | 500 | 1.0 | bal. | 0.5 | 10 | 180 | 0 | 40 | 3000< | Comparative Example |
| 30 | 8.0 | 3.0 | 20 | 500 | 1.0 | bal. | 0.5 | 8 | 180 | 0 | 72 | 460 | Example |
| 31 | 10.0 | 3.0 | 20 | 500 | 1.0 | bal. | 0.5 | 8 | 180 | 0 | 72 | 460 | Example |
| 32 | 12.0 | 3.0 | 20 | 500 | 1.0 | bal. | 0.5 | 8 | 180 | 0 | 72 | 460 | Example |
| 33 | 8.0 | 3.0 | 50 | 500 | 1.0 | bal. | 0.5 | 8 | 180 | 0 | 72 | 450 | Example |
| 34 | 8.0 | 3.0 | 100 | 500 | 1.0 | bal. | 0.5 | 8 | 180 | 0 | 72 | 450 | Example |
| 35 | 8.0 | 3.0 | 500 | 500 | 1.0 | bal. | 0.5 | 8 | 180 | 0 | 72 | 460 | Example |
| 36 | 8.0 | 3.0 | 1000 | 500 | 1.0 | bal. | 0.5 | 10 | 180 | 0 | 72 | 500 | Example |
| 37 | 8.0 | 3.0 | 100000 | 500 | 1.0 | bal. | 0.5 | 50< | 120 | 100 | 40 | 3000< | Comparative Example |
| 38 | 8.0 | 3.0 | 50 | 20 | 1.0 | bal. | 0.5 | 10 | 180 | 0 | 70 | 650 | Comparative Example |
| 39 | 8.0 | 3.0 | 50 | 30 | 1.0 | bal. | 0.5 | 10 | 180 | 0 | 70 | 700 | Comparative Example |
| 40 | 8.0 | 3.0 | 50 | 100 | 1.0 | bal. | 0.5 | 9 | 180 | 0 | 72 | 460 | Example |
| 41 | 8.0 | 3.0 | 50 | 300 | 1.0 | bal. | 0.5 | 8 | 180 | 0 | 72 | 460 | Example |
| 42 | 10.0 | 3.0 | 50 | 300 | 1.0 | bal. | 0.5 | 9 | 180 | 0 | 72 | 460 | Example |
| 43 | 12.0 | 3.0 | 50 | 300 | 1.0 | bal. | 0.5 | 10 | 180 | 0 | 72 | 460 | Example |
| 44 | 8.0 | 3.0 | 50 | 500 | 1.0 | bal. | 0.5 | 8 | 180 | 0 | 72 | 450 | Example |
| 45 | 8.0 | 3.0 | 50 | 600 | 1.0 | bal. | 0.5 | 8 | 180 | 0 | 72 | 450 | Example |
| 46 | 8.0 | 3.0 | 50 | 1000 | 1.0 | bal. | 0.5 | 9 | 180 | 0 | 72 | 460 | Example |
| 47 | 8.0 | 3.0 | 50 | 5000 | 1.0 | bal. | 0.5 | 9 | 180 | 0 | 72 | 470 | Example |
| 48 | 8.0 | 3.0 | 50 | 50000 | 1.0 | bal. | 0.5 | 50< | 140 | 100 | 50 | 3000< | Comparative Example |
| 49 | 8.0 | 3.0 | 50 | 100000 | 1.0 | bal. | 0.5 | 50< | 120 | 100 | 40 | 3000< | Comparative Example |
| 50 | 8.0 | 3.0 | 50 | 500 | 0.3 | bal. | 0.5 | 8 | 181 | 0 | 72 | 440 | Example |
| 51 | 8.0 | 3.0 | 50 | 500 | 1.0 | bal. | 0.5 | 8 | 180 | 0 | 72 | 450 | Example |
| 52 | 8.0 | 3.0 | 50 | 500 | 2.0 | bal. | 0.5 | 8 | 175 | 0 | 72 | 470 | Example |
| 53 | 8.0 | 3.0 | 50 | 500 | 3.0 | bal. | 0.5 | 9 | 170 | 0 | 72 | 500 | Example |
| 54 | 8.0 | 3.0 | 50 | 500 | 10.0 | bal. | 0.5 | 50< | 110 | 0 | 72 | 3000< | Comparative Example |
| 55 | 8.0 | 3.0 | 50 | 500 | 1.0 | bal. | 0.04 | 50 | 160 | 0 | 50 | 3000< | Comparative Example |
| 56 | 8.0 | 3.0 | 50 | 500 | 1.0 | bal. | 0.1 | 10 | 170 | 0 | 72 | 430 | Example |
| 57 | 8.0 | 3.0 | 50 | 500 | 1.0 | bal. | 0.2 | 10 | 172 | 0 | 72 | 440 | Example |
| 58 | 8.0 | 3.0 | 50 | 500 | 1.0 | bal. | 0.3 | 9 | 175 | 0 | 72 | 450 | Example |
| 59 | 8.0 | 3.0 | 50 | 500 | 1.0 | bal. | 0.4 | 9 | 178 | 0 | 72 | 450 | Example |
| 60 | 8.0 | 3.0 | 50 | 500 | 1.0 | bal. | 0.6 | 8 | 180 | 0 | 72 | 450 | Example |
| 61 | 8.0 | 3.0 | 50 | 500 | 1.0 | bal. | 0.8 | 8 | 182 | 0 | 72 | 460 | Example |
| 62 | 10.0 | 3.0 | 50 | 500 | 1.0 | bal. | 0.2 | 11 | 170 | 0 | 72 | 440 | Example |
| 63 | 10.0 | 3.0 | 50 | 500 | 1.0 | bal. | 0.3 | 10 | 173 | 0 | 72 | 450 | Example |
| 64 | 10.0 | 3.0 | 50 | 500 | 1.0 | bal. | 0.4 | 10 | 176 | 0 | 72 | 450 | Example |
| 65 | 10.0 | 3.0 | 50 | 500 | 1.0 | bal. | 0.6 | 9 | 178 | 0 | 72 | 450 | Example |
| 66 | 10.0 | 3.0 | 50 | 500 | 1.0 | bal. | 0.8 | 9 | 180 | 0 | 72 | 460 | Example |
| 67 | 12.0 | 3.0 | 50 | 500 | 1.0 | bal. | 0.3 | 11 | 171 | 0 | 72 | 450 | Example |
| 68 | 12.0 | 3.0 | 50 | 500 | 1.0 | bal. | 0.4 | 11 | 174 | 0 | 72 | 450 | Example |
| 69 | 12.0 | 3.0 | 50 | 500 | 1.0 | bal. | 0.6 | 10 | 176 | 0 | 72 | 450 | Example |
| 70 | 12.0 | 3.0 | 50 | 500 | 1.0 | bal. | 0.8 | 10 | 178 | 0 | 72 | 460 | Example |
| 71 | 8.0 | 3.0 | 50 | 500 | 1.0 | bal. | 1.0 | 8 | 185 | 0 | 72 | 480 | Example |
| 72 | 8.0 | 3.0 | 50 | 500 | 1.0 | bal. | 2.0 | 8 | 187 | 0 | 72 | 500 | Example |
| 73 | 8.0 | 3.0 | 50 | 500 | 1.0 | bal. | 3.0 | 7 | 190 | 0 | 72 | 1200 | Comparative Example |
| 74 | 8.0 | 3.0 | 50 | 500 | 1.0 | bal. | 5.0 | 7 | 192 | 0 | 72 | 3000< | Comparative Example |
| 75 | 8.0 | 3.0 | 50 | 500 | 1.0 | bal. | 10.0 | 6 | 195 | 0 | 72 | 3000< | Comparative Example |

All of the present examples are metal powders that have low coercivity of 12 Oe or less, keep high saturation magnetization of 170 emu/g or more, and have excellent rust resistance, the metal powders having the remarkable effect of producing a low iron-loss dust core with an iron loss of 500 kW/m³ or less when made into a dust core.

Comparative examples that fall outside the scope of the present invention either are metal powders that have coercivity higher than 12 Oe, saturation magnetization lower than 170 emu/g, or reduced rust resistance, or have a low volume fraction of less than 70% in resin when made into a dust core, resulting in a dust core with high iron loss exceeding 650 kW/m³.

In Table 1, the metal powders No. 1 to 9 indicate the data in which the O (oxygen) content was 0.3% and the Si content was varied, No. 10 to 20 indicate the data in which the O (oxygen) content was 1.0% and the Si content was varied, No. 21 to 28 indicate the data in which the Cr content was varied and the Si content was partly varied, No. 29 to 37 indicate the data in which the Cl content was varied and the Si content was also varied, No. 38 to 49 indicate the data in which the S (sulfur) content was varied and the Si content was also partly varied, No. 50 to 54 indicate the data in which the O (oxygen) content was varied, and No. 55 to 75 indicate the data in which the average particle diameter was varied and the Si content was also partly varied. The underlined data indicates that the data is outside the suitable range, and, for example, "50 <" means "more than 50".

## Claims

1. A metal powder comprising from 1.0% to 15.0% of Si, from 1.0% to 13.0% of Cr, from 10 ppm to 10000 ppm of Cl, from 100 ppm to 10000 ppm of S (sulfur), and from 0.2% to 7.0% of O (oxygen) by mass concentration, the remainder comprising Fe and unavoidable impurities, wherein the average particle diameter of the metal powder is from 0.1 um to 2.0 µm.

2. A green compact which is a bonded product of the metal powder described in claim 1 and a resin.

3. The green compact according to claim 2, wherein the resin is a thermosetting resin, a UV curable resin, or a thermoplastic resin.

4. A method for producing a metal powder by chemical vapor deposition, wherein the metal powder comprises from 1.0% to 15.0% of Si, from 1.0% to 13.0% of Cr, from 10 ppm to 10000 ppm of Cl, from 100 ppm to 10000 ppm of S (sulfur), and from 0.2% to 7.0% of O (oxygen) by mass concentration, the remainder comprising Fe and unavoidable impurities, wherein the average particle diameter of the metal powder is from 0.1 um to 2.0 µm.

5. A method for producing a green compact, comprising producing a metal powder by chemical vapor deposition, mixing the metal powder with a resin, and compression molding the mixture, wherein the metal powder comprises from 1.0% to 15.0% of Si, from 1.0% to 13.0% of Cr, from 10 ppm to 10000 ppm of Cl, from 100 ppm to 10000 ppm of S (sulfur), and from 0.2% to 7.0% of O (oxygen) by mass concentration, the remainder comprising Fe and unavoidable impurities.

6. A method for producing a green compact according to claim 5, wherein the resin is a thermosetting resin, a UV curable resin, or a thermoplastic resin.
